Europäisches Patentamt

European Patent Office

Office européen des brevets

(11) Publication number: **0 275 343**
**A1**

# EUROPEAN PATENT APPLICATION

(21) Application number: **87100961.9**

(22) Date of filing: **23.01.87**

(51) Int. Cl.⁴ **H01L 39/12**

(43) Date of publication of application:
**27.07.88 Bulletin 88/30**

(84) Designated Contracting States:
**AT BE CH DE ES FR GB GR IT LI LU NL SE**

(71) Applicant: **International Business Machines Corporation**
**Old Orchard Road**
**Armonk, N.Y. 10504(US)**

(72) Inventor: **Bednorz, Johannes Georg, Dr.**
**Sonnenbergstrasse 47**
**CH-8134 Adliswil(CH)**
Inventor: **Müller, Carl Alexander, Prof.Dr..**
**Haldenstrasse 54**
**CH-8908 Hedingen(CH)**
Inventor: **Takashige, Masaaki, Dr.**
**Rotfarbweg 1**
**CH-8803 Rüschlikon(CH)**

(74) Representative: **Rudack, Günter O., Dipl.-Ing.**
**IBM Corporation Säumerstrasse 4**
**CH-8803 Rüschlikon(CH)**

(54) **New superconductive compounds of the K2NiF4 structural type having a high transition temperature, and method for fabricating same.**

(57) The superconductive compounds are oxides of the general formula $RE_{2-x}AE_xTM.O_{4-y}$ , wherein RE is a rare earth, AE is a member of the group of alkaline earths or a combination of at least two member of that group, and TM is a transition metal, and wherein $x < 0.3$ and $0.1 \leq y \leq 0.5$. The method for making these compounds involves the steps of coprecipitating aqueous solutions of the respective nitrates of the constituents and adding the coprecipitate to oxalic acid, decomposing the precipitate and causing a solid-state reaction at a temperature between 500 and 1200°C for between one and eight hours, forming pellets of the powdered product at high pressure, sintering the pellets at a temperature between 500 and 1000°C for between one half and three hours, and subjecting the pellets to an additional annealing treatment at a temperature between 500 and 1200°C for between one half and five hours in a protected atmosphere permitting the adjustment of the oxygen content of the final product.

# NEW SUPERCONDUCTIVE COMPOUNDS OF THE $K_2NiF_4$ STRUCTURAL TYPE HAVING A HIGH TRANSITION TEMPERATURE, AND METHOD FOR FABRICATING SAME

Field of the Invention

The invention relates to a new class of superconductors, in particular to components of the $K_2NiF_4$ type of structure having superconductor properties below a relatively high transition temperature, and to a method for manufacturing those compounds.

Background of the Invention

Superconductivity is usually defined as the complete loss of electrical resistance of a material at a well-defined temperature. It is known to occur in many materials: About a quarter of the elements and over 1000 alloys and components have been found to be superconductors. Superconductivity is considered a property of the metallic state of the material, in that all known superconductors are metallic under the conditions that cause them to superconduct. A few normally non-metallic materials, for example, become superconductive under very high pressure, the pressure converting them to metals before they become superconductors.

Superconductors are very attractive for the generation and energy-saving transport of electrical power over long distances, as materials for forming the coils of strong magnets for use in plasma and nuclear physics, in nuclear resonance medical diagnosis, and in connection with the magnetic levitation of fast trains. Power generation by thermonuclear fusion, for example, will require very large magnetic fields which can only be provided by superconducting magnets. Certainly, superconductors will also find application in computers and high-speed signal processing and data communication.

While the advantages of superconductors are quite obvious, the common disadvantage of all superconductive materials so far known lies in their very low transition temperature (usually called the critical temperature $T_c$) which is typically on the order of a few degrees Kelvin. The element with the highest $T_c$ is niobium (9,2 K), and the highest known $T_c$ is about 23 K for $NB_3Ge$ at ambient pressure.

Accordingly, most known superconductors require liquid helium for cooling and this, in turn, requires an elaborate technology and as a matter of principle involves a considerable investment in cost and energy.

It is, therefore, an object of the present invention to propose compositions for high-$T_c$ superconductors and a manufacturing method for producing compounds which exhibit such a high critical temperature that cooling with liquid helium is obviated so as to considerably reduce the cost involved and to save energy.

The present invention proposes to use compounds having a layer-type structure of the kind known from potassium nickel fluoride $K_2NiF_4$. This structure is in particular present in oxides of the general composition $RE_2TM.O_4$, wherein RE stands for the rare earths (lanthanides) and TM stands for the so-called transition metals. It is a characteristic of the present invention that in the compounds in question the RE portion is partially substituted by one member of the alkaline earth group of metals, or by a combination of the members of this alkaline earth group, and that the oxygen content is at a deficit.

For example, one such compound that meets the description given above is lanthanum copper oxide $La_2CuO_4$ in which the lanthanum -which belongs to the IIIB group of elements-is in part substituted by one member of the neighboring IIA group of elements, viz. by one of the alkaline earth metals (or by a combination of the members of the IIA group), e.g., by barium. Also, the oxygen content of the compound is incomplete such that the compound will have the general composition $La_{2-x}Ba_xCuO_{4-y}$, wherein $x \leq 0.3$ and $y < 0.5$.

Another example for a compound meeting the general formula given above is lanthanum nickel oxide wherein the lanthanum is partially substituted by strontium, yielding the general formula $La_{2-x}Sr_xNiO_{4-y}$. Still another example is cerium nickel oxide wherein the cerium is partially substituted by calcium, resulting in $Ce_{2-x}Ca_xNiO_{4-y}$.

The following description will mainly refer to barium as a partial replacement for the lanthanum in a $La_2CuO_4$ compound because it is the Ba-La-Cu-O system which is, at least at present, the best understood system of all possible. Some compounds of the Ba-La-Cu-O system have been described by C. Michel and B. Raveau in Rev. Chim. Min. 21 (1984) 407, and by C. Michel, L. Er-Rakho and B. Raveau in Mat. Res. Bull., Vol. 20, (1985) 667-671. They did, however, not find nor try to find, superconductivity.

Experiments conducted in connection with the present invention have revealed that high-$T_c$ superconductivity is present in compounds where the rare earth is partially replaced by any one or more of the other members of the same IIA group of elements, i.e. the other alkaline earth metals. Actually, the $T_c$ of $La_2CuO_{4-y}$ with $Sr^2$ is higher and is superconductivity-induced diamagnetism larger than that found with $Ba^2$ and $Ca^2$.

As a matter of fact, only a small number of oxides is known to exhibit superconductivity, among them the Li-Ti-O system with onsets of superconductivity as high as 13,7 K, as reported by D.C. Johnston, H. Prakash, W.H. Zachariasen and R. Visvanathan in Mat. Res. Bull. 8 (1973) 777. Other known superconductive oxides include Nb-doped $SrTiO_3$ and $BaPb_{1-x}Bi_xO_3$, reported respectively by A. Baratoff and G. Binnig in Physics 108B (1981) 1335, and by A.W. Sleight, J.L. Gillson and F.E. Bierstedt in Solid State Commun. 17 (1975) 27.

The X-ray analysis conducted by Johnston et al. revealed the presence in their Li-Ti-O system of three different crystallographic phases, one of them, with a spinel structure, showing the high critical temperature. The Ba-La-Cu-O system, too, exhibits a number of crystallographic phases, namely with mixed-valent copper constituents which have itinerant electronic states between non-Jahn-Teller $Cu^3$ and Jahn-Teller $Cu^2$ ions.

This applies likewise to systems where nickel is used in place of copper, with $Ni^3$ being the Jahn-Teller constituent, and $Ni^2$ being the non-Jahn-Teller constituent.

The existence of Jahn-Teller polarons is conducting crystals was postulated theoretically by K.H. Hoeck, H. Nickisch and H. Thomas in Helv. Phys. Acta 56 (1983) 237. Polarons have large electron-phonon interactions and, therefore, are favorable to the occurrence of superconductivity at high critical temperatures.

Generally, the Ba-La-Cu-O system, when subjected to X-ray analysis reveales three individual crystallographic phases, viz.
- a first layer-type perovskite-like phase, related to the $K_2NiF_4$ structure, with the general composition $La_{2-x}Ba_xCuO_{4-y}$, with $X \ll 1$ and $y \geq 0$;
- a second, non-conducting CuO phase; and
- a third, nearly cubic perovskite phase of the general composition $La_{1-x}Ba_xCuO_{3-y}$ which appears to be independent of the exact starting composition,
as has been reported in the paper by J.G. Bednorz and K.A. Müller in Z. Phys. B - Condensed Matter 64 (1986) 189-193. Of these three phases the first one appears to be responsible for the high-$T_c$ superconductivity, the critical temperature showing a dependence on the barium concentration in that phase. Obviously, the $Ba^2$ substitution causes a mixed-valent state of $Cu^2$ and $Cu^3$ to preserve charge neutrality. It is assumed that the oxygen deficiency, $y$, is the same in the doped and undoped crystallites.

Both $La_2CuO_4$ and $LaCuO_3$ are metallic conduc-

tors at high temperatures in the absence of barium. Actually, both are metals like $LaNiO_3$. Despite their metallic character, the Ba-La-Cu-O type materials are ceramics, as are the other compounds of the $RE_2TM.O_4$ type, and their manufacture more or less follows the known principles of ceramic fabrication. The preparation of a Ba-La-Cu-O compound, for example, in accordance with the present invention typically involves the following manufacturing steps:
- Preparing aqueous solutions of the respective nitrates of barium, lanthanum and copper and coprecipitation therof in their appropriate ratios.
- Adding the coprecipitate to oxalic acid and forming an intimate mixture of the respective oxalates.
- Decomposing the precipitate and causing a solid-state reaction by heating the precipitate to a temperature between 500 and 1200°C for one to eight hours.
- Pressing the resulting product at a pressure of about 4 kbar to form pellets.
- Re-heating the pellets to a temperature between 500 and 900°C for one half to three hours for sintering.

It will be evident to those skilled in the art that if the partial substitution of the lanthanum by strontium or calcium is desired, the particular nitrate thereof will have to be used in place of the barium nitrate of the example described above. Also, if the copper of this example is to be replaced by another transition metal, the nitrate thereof will obviously have to be employed.

Experiments have shown that the partial contents of the individual compounds in the starting composition play an important role in the formation of the phases present in the final product. While, as mentioned above, the final Ba-La-Cu-O system obtained generally contains the said three phases, with the second phase being present only to a very small amount, the partial substitution of lanthanum by strontium or calcium (and perhaps beryllium) will result in only one phase existing in the final $La_{2-x}Sr_xCuO_{4-y}$ or $La_{2-x}Ca_xCuO_{4-y}$, respectively, provided $x < 0.3$.

With a ratio of 1:1 for the respective (Ba, La) and Cu contents, one may expect the said three phases to occur in the final product. Setting aside the said second phase, i.e. the CuO phase, whose amount is negligible, the relative volume amounts of the other two phases are dependent on the barium contents in the $La_{2-x}Ba_xCuO_{4-y}$ complex. At the 1:1 ratio and with an $x = 0.02$, the onset of a localization transition is observed, i.e., the resistivity increases with decreasing temperature, and there is no superconductivity.

With $x = 0.1$ at the same 1:1 ratio, there is a resistivity drop at the very high critical temperature of 35 K.

With a (Ba,La) versus Cu ratio of 2:1 in the starting composition, the composition of the $La_2CuO_4$:Ba phase, which was assumed to be responsible for the serconductivity, is imitated, with the result that now only two phases are present, the CuO phase not existing. With a barium content of $x = 0.15$, the resistivity drop occurs at $T_c = 26$ K.

The method for preparing the Ba-La-Cu-O complex involves two heat treatments for the precipitate at an elevated temperature for several hours. In the experiments carried out in connection with the present invention it was found that best results were obtained at 900°C for a decomposition and reaction period of 5 hours, and again at 900°C for a sintering period of one hour. These values apply to a ratio 1:1 composition as well as to a 2:1 composition.

For the ratio 2:1 composition, a somewhat higher temperature is permissible owing to the melting point of the composition being higher in the absence of excess copper oxide. Yet it is not possible by high-temperature treatment to obtain a one-phase compound.

Measurements of the dc conductivity were conducted between 300 and 4.2 K. For barium-doped samples, for example, with $x < 0.3$, at current densities of 0.5 A/cm², a high-temperature metallic behavior with an increase in resistivity at low temperatures was found. At still lower temperatures, a sharp drop in resistivity (>90%) occurred which for higher current densities became partially suppressed. This characteristic drop was studied as a function of the annealing conditions, i.e. temperature and oxygen partial pressure. For samples annealed in air, the transition from itinerant to localized behavior was not found to be very pronounced, annealing in a slightly reducing atmosphere, however, led to an increase in resistivity and a more pronounced localization effect. At the same time, the onset of the resistivity drop was shifted towards higher values of the critical temperature. Longer annealing times, however, completely destroy the superconductivity.

Cooling the samples from room temperature, the resistivity data first show a metal-like decrease. At low temperatures, a change to an increase occurs in the case of Ca compounds and for the Ba-substituted samples. This increase is followed by a resistivity drop, showing the onset of superconductivity at 22±2 K and 33±2 K for the Ca and Ba compounds, respectively. In the Sr compound, the resistivity remains metallic down to the resistivity drop at 40±1 K. The presence of localization effects, however, depends strongly on alkaline-earth ion concentration and sample preparation, that is to say, annealing conditions and also on the density which have to be optimized. All samples with low concentrations of Ca, Sr, and Ba show a strong tendency to localization before the resistivity drop occur.

Apparently, the onset of the superconductivity, i.e the value of the critical temperature $T_c$, is dependent, among other parameters, on the oxygen content of the final compound. It seems that a certain oxygen deficiency is necessary for the material to have a high-$T_c$ behavior. In accordance with the present invention, the method described above for making the $La_2CuO_4$:Ba complex is complemented by an annealing step during which the oxygen content of the final product can be adjusted. Of course, what was said in connection with the formation of the $La_2CuO_4$:Ba compound, likewise applies to other compounds of the general formula $RE_2TM.O_4$:AE, such as, e.g. $Nd_2NiO_4$:Sr.

In the cases where a heat treatment for decomposition and reaction and/or for sintering was performed at a relatively low temperature, i.e. at no more than 950°C, the final product is subjected to an annealing step at about 900°C for about one hour in a reducing atmosphere. It is assumed that the net effect of this annealing step is a removal of oxygen atoms from certain locations in the matrix of the $RE_2TM.O_4$ complex, thus creating a distortion in its crystalline structure. The $O_2$ partial pressure for annealing in this case may be between $10^1$ and $10^5$ bar.

In those cases where a relatively high temperature (i.e. above 950°C) was employed for the heat treatment, it might be advantageous to perform the annealing step in a slightly oxidizing atmosphere. This would make up for an assumed exaggerated removal of oxygen atoms from the system owing to the high temperature and resulting in a too severe distortion of the system's crystalline structure.

Resistivity and susceptibility measurements, as a function of temperature, of $Sr^2$ and $Ca^2$-doped $La_2CuO_{4-y}$ ceramics show the same general tendency as the $Ba^2$-doped samples: A drop in resistivity $\rho(T)$, and a crossover to diamagnetism at a slightly lower temperature. The samples containing $Sr^2$ actually yielded a higher onset than those containing $Ba^2$ and $Ca^2$. Furthermore, the diamagnetic susceptibility is about three times as large as for the Ba samples. As the ionic radius of $Sr^2$ nearly matches the one of $La^3$, it seems that the size effect does not cause the occurrence of superconductivity. On the contrary, it is rather adverse, as the data on $Ba^2$ and $Ca^2$ indicate.

The highest $T_c$'s for each of the dopant ions investigated occur for those concentrations where, at room temperature, the $Re_{2-x}TM_xO_{4-y}$ structure is close to the orthorhombic-tetragonal structural phase transition which may be related to the substantial electron-phonon interaction enhanced by the substitution. The alkaline-earth substitution of the rare earth metal is clearly important, and quite likely creates TM ions with no $e_g$ Jahn-Teller orbitals. Therefore, the absence of these J.-T. orbitals, that is, J.-T. holes near the Fermi energy probably plays an important role for the $T_c$ enhancement.

## Claims

1) Superconductive compound of the $RE_2TM.O_4$ type having a transition temperature above 26 K, wherein the rare earth (RE) is partially substituted by one or more members of the alkaline earth groups of elements (AE), and wherein the oxygen content is adjusted such that the resulting crystal structure is distorted and comprises a phase of the general composition $RE_{2-x}AE_xTM.O_{4-y}$, wherein TM represents a transition metal, and $x < 0.3$ and $y < 0.5$.

2) Compound in accordance with claim 1, wherein the rare earth (RE) is lanthanum and the transition metal (TM) is copper.

3) Compound in accordance with claim 1, wherein the rare earth is cerium and the transition metal is nickel.

4) Compound in accordance with claim 1, wherein the rare earth is lanthanum and the transition metal is nickel.

5) Compound in accordance with claim 1, wherein barium is used as a partial substitute for the rare earth, with $x < 0.3$ and $0.1 \leq y \leq 0.5$.

6) Compound in accordance with claim 1, wherein calcium is used as a partial substitute for the rare earth, with $x < 0.3$ and $0.1 \leq y \leq 0.5$.

7) Compound in accordance with claim 1, wherein strontium is used as a partial substitute for the rare earth, with $x < 0.3$ and $0.1 \leq y \leq 0.5$.

8) Compound in accordance with claim 1, wherein the rare earth is lanthanum and the transition metal is chromium.

9) Compound is accordance with claim 1, wherein the rare earth is neodymium and the transition metal is copper.

10) Method for making superconductive compounds of the $RE_2TM.O_4$ type, with RE being a rare earth, TM being a transition metal, the compounds having a transition temperature above 26 K, comprising the steps of:
- preparing aqueous solutions of the nitrates of the rare earth and transition metal constituents and of one or more of the alkaline earth metals and coprecipitation thereof in their appropriate ratios;
- adding the coprecipitate to oxalic acid and forming an intimate mixture of the respective oxalates;
- decomposing the precipitate and causing a solid-state reaction by heating the precipitate to a temperature between 500 and 1200°C for a period of time between one and eight hours;
- allowing the resultant powder product to cool;
- pressing the powder at a pressure of between 2 and 10 kbar to form pellets;
- re-adjusting the temperature of the pellets to a value between 500 and 1000°C for a period of time between one half and three hours for sintering;
- subjecting the pellets to an additional annealing treatment at a temperature between 500 and 1200°C for a period of time between one half and 5 hours in a protected atmosphere permitting the adjustment of the oxygen content of the final product which has a final composition of the form $RE_{2-x}TM.O_{4-y}$, wherein $x < 0.3$ and $0.1 < y < 0.5$.

11) Method in accordance with claim 10, wherein the protected atmosphere is pure oxygen.

12) Method in accordance with claim 10, wherein the protected atmosphere is a reducing atmosphere with an oxygen partial pressure between $10^1$ and $10^5$ bar.

13) Method in accordance with claim 10, wherein the decomposition step is performed at a temperature of 900°C for 5 hours, and wherein the annealing step is performed at a temperature of 900°C for one hour in a reducing atmosphere with an oxygen partial pressure between $10^1$ and $10^5$ bar.

14) Method in accordance with claim 10, wherein lanthanum is used as the rare earth and copper is used as the transition metal, and wherein barium is used to partially substitute for the lanthanum, with $x < 0.2$, wherein the decomposition step is performed at a temperature of 900°C for 5 hours, and wherein the annealing step is performed in a reducing atmosphere with an oxygen partial pressure on the order of $10^3$ bar and at a temperature of 900°C for one hour.

15) Method in accordance with claim 10, wherein lanthanum is used as the rare earth and nickel is used as the transition metal, and wherein barium is used to partially substitute for the lanthanum, with $x < 0.2$, wherein the decomposition step is performed at a temperature of 900°C for 5 hours, and wherein the annealing step is performed in a reducing atmosphere with an oxygen partial pressure on the order of $10^3$ bar and at a temperature of 900°C for one hour.

16) Method in accordance with claim 10, wherein lanthanum is used as the rare earth and copper is used as the transition metal, and wherein calcium is used to partially substitute for the lanthanum, with $x < 0.2$, wherein the decomposition step is performed at a temperature of 900°C for 5 hours, and wherein the annealing step is performed in a reducing atmosphere with an oxygen partial pressure on the order of $10^3$ bar and at a temperature of 900°C for one hour.

17) Method in accordance with claim 10, wherein lanthanum is used as the rare earth and copper is used as the transition metal, and wherein strontium is used to partially substitute for the lanthanum, with $x < 0.2$, wherein the decomposition step is performed at a temperature of 900°C for 5 hours, and wherein the annealing step is performed in a reducing atmosphere with an oxygen partial pressure on the order of $10^3$ bar and at a temperature of 900°C for one hour.

18) Method in accordance with claim 10, wherein cerium is used as the rare earth and nickel is used as the transition metal, and wherein barium is used to partially substitute for the cerium, with $x < 0.2$, wherein the decomposition step is performed at a temperature of 900°C for 5 hours, and wherein the annealing step is performed in a reducing atmosphere with an oxygen partial pressure on the order of $10^3$ bar and at a temperature of 900°C for one hour.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,A | REVUE DE CHIMIE MINERALE, vol. 21, 1984, pages 407-425, Paris, FR; C. MICHEL et al.: "Oxygen intercalation in mixed valence copper oxides related to the perovskites" <br> * page 417, paragraph 2 - page 425 * | 1 | H 01 L 39/12 |

-----

TECHNICAL FIELDS
SEARCHED (Int. Cl.4)

H 01 L 39/00

The present search report has been drawn up for all claims

| Place of search | Date of completion of the search | Examiner |
|---|---|---|
| BERLIN | 17-07-1987 | ROUSSEL A T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82